# EUROPÄISCHE PATENTSCHRIFT

(11) **EP 3 586 356 B1**
(45) Veröffentlichungstag und Bekanntmachung des Hinweises auf die Patenterteilung: **08.11.2023**
(21) Anmeldenummer: 17706731.1
(22) Anmeldetag: 21.02.2017
(51) Int. Cl.: H01L 21/20, H01L 21/687, H01L 23/00

(54) **VERFAHREN ZUM BONDEN VON SUBSTRATEN**
METHOD FOR BONDING SUBSTRATES
PROCÉDÉ DE LIAISON DE SUBSTRATS

(43) Veröffentlichungstag der Anmeldung: 01.01.2020
(73) Patentinhaber: EV Group E. Thallner GmbH, 4782 St. Florian am Inn (AT)
(72) Erfinder: HINGERL, Kurt, 4493 Wolfern Österreich (AT); OBERHUMER, Peter, Nikolas, 4673 Gaspoltshofen Österreich (AT); HESSER, Günter, 4020 Linz Österreich (AT)
(74) Vertreter: Schneider, Sascha
(86) Internationale Anmeldenummer: PCT/EP2017/053918
(87) Internationale Veröffentlichungsnummer: WO 2018/153434

(56) Entgegenhaltungen:
- EP-A1- 2 058 080
- WO-A1-2015/174252
- US-A1- 2006 068 563
- US-A1- 2013 112 650
- US-A1- 2017 025 306

## Beschreibung

Die vorliegende Erfindung betrifft ein Verfahren gemäß dem Patentanspruch 1. In der Halbleiterindustrie werden bereits seit mehreren Jahren unterschiedliche Bondtechnologien verwendet, um Substrate miteinander zu fügen. Den Verbindungsvorgang nennt man Bonden. Es wird insbesondere zwischen den Temporärbondverfahren und den Permanentbondverfahren unterschieden.

US2017025306A1 offenbart Verfahren zur Herstellung von Silizium-auf-Isolator-Strukturen und verwandten Zwischenstrukturen. EP2058080A1 offenbart ein Verfahren zum Verbinden einer Vielzahl von Substraten bei Raumtemperatur über ein Zwischenelement. US2006068563 offenbart ein Verfahren zur Herstellung einer Halbleiterstruktur und die Bereitstellung einer Schichtstruktur auf einem ersten Substrat, wobei die Schichtstruktur eine Siliziumschicht umfasst, die über einer ersten dielektrischen Schicht bereitgestellt wird. WO2015174252A1 offenbart ein Verfahren zur Herstellung von Halbleitersubstraten, bei dem das Verteilungsprofil bestimmter Atome, die in ein Substrat implantiert werden, um amorphe Schichten zu bilden, in geeigneter Weise gesteuert werden kann. US20130112650A1 offenbart, dass auf zu bondende Oberflächen Metallschichten aufgetragen werden, welche mittels Laserstrahl lokal aufgeschmolzen werden.

Bei den Temporärbondverfahren wird insbesondere ein Produktsubstrat mit einem Trägersubstrat so verbondet, dass es nach einer Prozessierung wieder gelöst werden kann. Mit Hilfe der Temporärbondverfahren ist es möglich, das Produktsubstrat mechanisch zu stabilisieren. Die mechanische Stabilisierung garantiert, dass sich das Produktsubstrat handhaben lässt, ohne sich zu wölben, zu verformen oder zu brechen. Stabilisierungen durch Trägersubstrate sind vor allem während und nach einem Rückdünnprozess notwendig. Ein Rückdünnprozess erlaubt die Reduzierung der Produktsubstratdicke auf wenige Mikrometer.

Bei den Permanentbondverfahren werden mindestens zwei Substrate dauerhaft, permanent, miteinander verbondet. Das permanente Verbonden zweier Substrate erlaubt auch die Herstellung von mehrlagigen Strukturen. Diese mehrlagigen Strukturen können aus denselben oder aus unterschiedlichen Materialien bestehen.

Das Permanentbondverfahren des anodischen Bondens wird verwendet, um ionenhaltige Substrate permanent miteinander zu verbinden. In den meisten Fällen handelt es sich bei einem der beiden Substrate um ein Glassubstrat.

Ein weiteres Permanentbondverfahren ist das Metallbonden. Beim Metallbonden wird eine Legierung zwischen den zu verbondenden Substraten erstellt oder es erfolgt eine homoatomare, also nur aus einer Atomsorte bestehenden, Verbindung. Bei einem möglichen Erstarrungsvorgang erstarrt die flüssige Phase und bildet die Verbindungsschicht zwischen den beiden Substraten. Denkbar ist auch eine Verbindung ohne Bildung einer schmelzflüssigen Phase.

Ein weiteres Permanentbondverfahren ist das Fusionsbonden, auch als Direktbonden bezeichnet. Beim Fusionsbonden werden zwei ebene, reine Substratoberflächen durch Kontaktierung miteinander verbondet. Der Bondvorgang teilt sich dabei in zwei Schritte. In einem ersten Schritt erfolgt eine Kontaktierung der beiden Substrate. Die Fixierung der beiden Substrate erfolgt dabei vorwiegend durch van-der-Waals Kräfte. Die Fixierung bezeichnet man als Vorbond (engl.: prebond). Diese Kräfte erlauben die Herstellung einer Fixierung, die stark genug ist, um die Substrate so fest miteinander zu verbonden, dass eine gegenseitige Verschiebung, insbesondere durch das Aufbringen einer Scherkraft, nur mehr mit erheblichem Kraftaufwand möglich ist. Andererseits können die beiden Substrate, insbesondere durch Anlegen einer Normalkraft, wieder relativ leicht voneinander getrennt werden. Die Normalkräfte greifen dabei vorzugsweise am Rand an, um eine Keilwirkung in der Grenzfläche beider Substrate zu bewirken, welche einen fortlaufenden Riss erzeugt und somit beide Substrate wieder voneinander trennt. Um einen permanenten Fusionsbond zu erzeugen, wird der Substratstapel einer Wärmebehandlung, auch Annealing genannt, unterzogen. Die Wärmebehandlung führt zur Ausbildung kovalenter Verbindungen zwischen den Oberflächen der beiden Substrate. Ein derartig erzeugter Permanentbond ist nur mehr durch die Aufwendung einer entsprechend hohen, in den meisten Fällen mit einer Zerstörung der Substrate einhergehenden Kraft lösbar.

Die für die Erzeugung der Bindungsstärke notwendige Wärmebehandlung stellt ebenfalls technische Herausforderungen. Die verbondeten Substrate sind sehr oft bereits mit funktionalen Einheiten wie beispielsweise Mikrochips, MEMs, Sensoren, LEDs versehen worden, die eine Temperaturempfindlichkeit besitzen. Insbesondere Mikrochips besitzen eine relativ starke Dotierung. Die Dotierelemente besitzen bei erhöhten Temperaturen eine erhöhte Diffusionsfähigkeit, die zu einer ungewollten, nachteiligen Verteilung der Dotierungen im Substrat führen kann. Des Weiteren sind Wärmebehandlungen immer mit erhöhten Temperaturen und damit auch mit höheren Kosten, mit der Erzeugung von thermischen Spannungen, thermisch bedingten Verschiebungen und mit längeren Prozesszeiten für das Aufheizen und Abkühlen verbunden. Deswegen soll bei möglichst niedrigen Temperaturen gebondet werden.

Weitere Verfahren zum Direktbonden stellen die oberflächenaktivierte Direktbonds dar. Mit Hilfe einer Oberflächenaktivierung mindestens eines der Substrate wird die Oberflächenenergie des Bonds erhöht, sodass bei Raumtemperatur Bondstärken entstehen, welche mit der Festigkeit des Substratmaterials vergleichbar sind.

Für eine Oberflächenaktivierung, mit deren Hilfe die Wärmebehandlungstemperatur bzw. Dauer reduziert werden kann, gibt es unterschiedliche Ansätze. Zur Behandlung der zu bondenden Oberflächen kann eine Plasmabehandlung oder eine Ionenstrahlbehandlung verwendet werden. Erfahrungsgemäß gehen die meisten, wenn nicht gar alle, Oberflächenaktivierungsverfahren mit einer Amorphisierung der zu bondenden Oberflächen einher.

Eine Plasmabehandlung zur Reinigung und Aktivierung einer Substratoberfläche wäre eine Möglichkeit, bei relativ geringen Temperaturen zu Bonden. Derartige Plasmaverfahren funktionieren allerdings nicht oder nur sehr schlecht bei sauerstoffaffinen Oberflächen, insbesondere bei Metalloberflächen. Die sauerstoffaffinen Metalle oxidieren und bilden im Allgemeinen relativ stabile Oxide. Die Oxide sind wiederum hinderlich für den Bondvorgang. Derartige oxidierte Metalle können auch relativ schwer durch Diffusionsbonds miteinander verbondet werden. Sehr gut hingegen funktioniert die Verbondung von Plasma aktiviertem, insbesondere monokristallinem, Silizium, welches eine Siliziumdioxidschicht ausbildet. Die Siliziumdioxidschicht eignet sich hervorragend zum Verbonden. Die genannten negativen Auswirkungen der Oxide beziehen sich daher nicht notwendigerweise auf alle Materialklassen.

Die Druckschrift US5441776 beschreibt ein Verfahren zum Bonden einer ersten Elektrode zu einer hydrogenierten, amorphen Siliziumschicht. Diese amorphe Siliziumschicht wird durch Abscheideprozesse an der Oberfläche eines Substrats abgeschieden.

Die Druckschrift US7462552B2 zeigt ein Verfahren auf, bei dem eine chemische Gasphasenabscheidung (engl.: chemical vapour deposition, CVD) verwendet wird, um eine amorphe Siliziumschicht an der Oberfläche eines Substrats abzuscheiden. Die amorphe Schicht besitzt eine Dicke zwischen 0.5 und 10µm.

In der Literatur existieren mehrere Ansätze, die das Direktbonden bei niedrigerer Temperatur beschreiben. Ein Ansatz in der PCT/EP2013/064239 besteht im Aufbringen einer Opferschicht, die während und/oder nach dem Bondprozess im Substratmaterial gelöst wird. Ein weiterer Ansatz in der PCT/EP2011/064874 beschreibt die Herstellung einer permanenten Verbindung durch Phasenumwandlungen. Die genannten Druckschriften beziehen sich insbesondere auf metallische Oberflächen, die eher über eine Metallbindung und nicht über kovalente Bindungen gebondet werden. In der PCT/EP2014/056545 wird ein optimierter Direktbondvorgang von Silizium durch eine Oberflächenreinigung beschrieben.

Einen weiteren Ansatz stellt WO2015197112A1 dar, bei welcher viele Nachteile der aufgeführten Technologien reduziert werden. So wird die Bondschicht einige 10 nm dünn gehalten, sodass insbesondere die optischen Eigenschaften des Stapels geringfügig beeinflusst werden.

Eine Art von Schweißverbindung stellen die Schriften US20130112650A1 sowie US20140230990A1 dar, wobei auf die zu bondenden Oberflächen Metallschichten aufgetragen werden, welche mittels Laserstrahl lokal aufgeschmolzen werden. Dadurch entstehen zumindest linienförmige Bonds, mit welchen die Substrate verbondet werden können.

Alle aufgeführten Verfahren sowie Bondvorrichtungen erzeugen nach einem Fügeverfahren einen verbondeten Substratstapel. Jedoch werden in allen Verfahren entweder Zusatzmaterialien wie Metalle und/oder deren Ionen verwendet oder es werden die Oxide und/oder Nitride der Substrate gebildet und miteinander verbunden.

Es ist daher die Aufgabe der vorliegenden Erfindung, die Nachteile des Stands der Technik zu beseitigen und insbesondere ein verbessertes Bondergebnis zu erzielen.

Diese Aufgabe wird mit dem Gegenstand des Anspruchs 1 gelöst. Vorteilhafte Weiterbildungen der Erfindung sind in den Unteransprüchen angegeben.

Erfindungsgemäß vorgesehen ist ein Verfahren zum Bonden eines ersten Substrats gemäß Anspruch 1.

Weiterhin offenbart ist eine Vorrichtung zum Bonden eines ersten Substrats mit einem zweiten Substrat, insbesondere mit einem erfindungsgemäßen Verfahren, aufweisend:
- eine Aufnahmeeinrichtung zur Aufnahme der Substrate,
- eine Bondeinrichtung zum Bonden der Substrate,
- eine Bestrahlungseinrichtung,
wobei die Vorrichtung derart ausgebildet ist,
- dass eine erste amorphe Schicht auf dem ersten Substrat und/oder eine zweite amorphe Schicht auf dem zweiten Substrat erzeugbar ist/sind,
- dass das erste Substrat mit dem zweiten Substrat an der amorphen Schicht oder an den amorphen Schichten zur Ausbildung eines Substratstapels verbindbar ist,
- dass die amorphe Schicht oder die amorphen Schichten mit einer Strahlung durch die Bestrahlungseinrichtung derart bestrahlbar ist/sind, dass die amorphe Schicht oder die amorphen Schichten in eine kristalline Schicht oder kristalline Schichten umwandelbar ist/sind.

Weiterhin wird ein Substratstapel offenbart, der mit einer offenbarten Vorrichtung und/oder einem erfindungsgemäßen Verfahren gebondet wurde.

Erfindungsgemäß können zwei einzelne Substrate miteinander gebondet werden. Es kann aber auch ein Substrat mit einem Substratstapel gebondet werden oder es können zwei Substratstapel miteinander gebondet werden. Ein Substratstapel besteht aus zwei oder mehreren gebondeten Substraten.

Ein zu bondendes Substrat bzw. Substratstapel kann nur auf einer Seite eine amorphe Schicht aufweisen oder auf beiden Seiten eine amorphe Schicht aufweisen.

Zur Vereinfachung ist im Folgenden mit Substrat stets sowohl ein einzelnes Substrat als auch ein Substratstapel gemeint, soweit nichts Anderes bestimmt ist.

Der Grundgedanke der Erfindung besteht darin, dass durch die mindestens eine amorphe Schicht eine gute Vorfixierung (Prebond) der Substrate hergestellt wird und durch die Umwandlung der amorphen Schicht(en) in die kristalline(n) Schicht(en) ein weitgehend übergangsfrei gebondeter Substratstapel erzeugt wird. Erfindungsgemäß ist die erzeugte Wärme durch korrekte Wahl der Laserwellenlänge vergleichsweise gering und lokal auf die amorphe(n) Schicht(en) begrenzt. So können Spannungen im Substratstapel stark reduziert werden. Zudem sind die Prozesszeiten vergleichsweise gering.

Die mindestens eine amorphe Schicht wird aus den elektrisch leitenden Oberflächenbereichen auf dem ersten Substrat und/oder aus den elektrisch leitenden Oberflächenbereichen auf dem zweiten Substrat, der Hybridsubstrate, erzeugt.

Während der Bestrahlung der amorphen Schicht(en) werden insbesondere durch van der Waalsche Kräfte entstandene Bindungen der Substrate in feste, insbesondere atomare, Bindungen, insbesondere in kovalente Bindungen, umgewandelt sowie vorhandene Defekte geschlossen. Erfindungsgemäß ist mindestens eines der Substrate mit einer amorphen

Schicht versehen. Wenn nur eines der Substrate mit einer amorphen Schicht versehen ist und das andere Substrat nicht mit einer amorphen Schicht versehen ist, dann werden die Substrate an der amorphen Schicht miteinander verbunden.

Bevorzugt wird auf beiden Substraten eine amorphe Schicht erzeugt und die Substrate werden an den amorphen Schichten miteinander verbunden. Dadurch kann vorteilhaft ein besonders fester Prebond erzeugt werden.

Bevorzugt ist mindestens eines der Substrate ein kristallines Substrat, besonders bevorzugt ein monokristallines Substrat. Ganz besonders bevorzugt sind beide Substrate kristalline Substrate, weiter bevorzugt monokristalline Substrate. Dadurch kann vorteilhaft die Strahlung die amorphe(n) Schicht(en) weitgehend ungestört erreichen, sodass eine Erwärmung der Substrate minimiert wird, wodurch Spannungen im Substratstapel minimiert werden können. Denkbar ist auch, dass die Substrate polykristallin, insbesondere sogar nanokristallin, sind. Insbesondere bei den, dem Fachmann bekannten, Hybridbonds, sind die miteinander zu verbindenden elektrisch leitenden Bereiche vorzugsweise polykristallin, bestehen insbesondere aus polykristallinem Kupfer. Das erfindungsgemäße Verfahren kann in solchen Fällen auch nur auf Teilbereiche eines Substrats angewandt werden, falls nötig und muss nicht notwendigerweise über die gesamte Fläche eines Substrats erfolgen. Besonders bevorzugt ist allerdings die vollflächige Amorphisierung aller elektrischen Bereiche einer Hybridoberfläche.

Die mindestens eine amorphe Schicht wird erfindungsgemäß zumindest bereichsweise in eine kristalline Schicht umgewandelt, sodass ein weitgehend übergangsfreier Substratstapel erzeugt wird. Bevorzugt wird die mindestens eine amorphe Schicht überwiegend in eine kristalline Schicht umgewandelt, ganz besonders bevorzugt vollständig. Dadurch kann vorteilhaft ein fast vollständig übergangsfreier bzw. vollkommen übergangsfreier Substratstapel erzeugt werden.

Bevorzugt ist weiterhin vorgesehen, dass die kristalline Phase des ersten und/oder des zweiten Substrats zu mindesten 50%, vorzugsweise zu mindesten 70%, noch bevorzugter zu mindestens 90%, am bevorzugtesten zu mindesten 95%, am allerbevorzugtesten zu mindestens 99% transparent für die verwendete Strahlung einer Strahlungsquelle ist. Dadurch kann die Strahlung weitgehend ungehindert die amorphe(n) Schicht(en) erreichen, sodass eine Umwandlung der amorphen Schicht(en) durch das Substrat hindurch möglich ist. Dadurch kann vorteilhaft die gesamte amorphe Schicht bzw. Schichten von der Strahlung erreicht werden. Zudem kann vorteilhaft die Strahlungsquelle der Strahlung auf der Rückseite der Substrate angeordnet werden. Die Rückseite ist diejenige Seite des Substrats, die der Bondoberfläche abgewandt ist.

Erfindungsgemäß absorbiert die mindestens eine amorphe Schicht die Strahlung zumindest teilweise. Bevorzugt wird mehr als 50% der Strahlungsenergie der Strahlung absorbiert, weiter bevorzugt mehr als 70%, besonders bevorzugt mehr als 80%, ganz besonders bevorzugt mehr als 90%. Dadurch kann vorteilhaft eine besonders effiziente Umwandlung in die kristalline Phase erfolgen.

Bevorzugt ist die Strahlung eine Laserstrahlung. Diese wird auf die mindestens eine amorphe Schicht fokussiert und wirkt somit lediglich auf die mindestens eine amorphe Schicht ein. Dadurch werden vorteilhaft die thermische Belastung des Substratstapels und damit die induzierten mechanischen Spannungen reduziert.

Bevorzugt ist weiterhin vorgehen, dass die Strahlung senkrecht auf die amorphe(n) Schicht(en) auftrifft. Senkrecht umfasst eine Abweichung von weniger als +/- 5 Grad, bevorzugt weniger als +/- 3 Grad, besonders bevorzugt weniger als +/- 1 Grad von der Senkrechten. Dadurch kann die Strahlung optimal von der mindestens einen amorphen Schicht absorbiert werden, sodass eine besonders effiziente Umwandlung in die kristalline Phase erreichbar ist. Zudem kann die Bestrahlung von der Rückseite des Substrats bzw. der Substrate erfolgen, wodurch die gesamte amorphe Schicht bzw. die gesamten amorphen Schichten von der Strahlung erreicht werden können. Zudem kann die Anordnung der Strahlungsquelle(n) und der Substrate vereinfacht werden, da eine Bestrahlung von der Seite nicht erforderlich ist.

Bevorzugt ist weiterhin vorgehen, dass die Strahlung durch einen Breitbandstrahler erzeugt wird, der im Energiebereich zwischen 1 eV und 10E6 eV strahlt, vorzugsweise zwischen 1 eV und 10E3 eV, noch bevorzugter zwischen 1 eV und 10 eV, am allerbevorzugtesten zwischen 1 eV und 3 eV. Vorteilhaft wird die Strahlung in diesen Energiebereichen von dem Substrat bzw. den Substraten weitgehend ungehindert durgelassen und von der bzw. den amorphen Schicht(en) absorbiert, sodass die Umwandlung in die kristalline Phase erfolgen kann. Dadurch kann die gesamte amorphe Schicht bzw. können die gesamte amorphen Schichten erreicht werden und eine Bestrahlung von der Rückseite des Substrats bzw. der Substrate erfolgen.

Bevorzugt ist weiterhin vorgehen, dass die Strahlungsleistung der Strahlung zwischen 0.01 Watt und 10000 Watt liegt, vorzugsweise zwischen 0.1 Watt und 1000 Watt, am allerbevorzugtesten zwischen 1 Watt und 100 Watt. In diesen Leistungsbereichen kann die mindestens eine amorphe Schicht auf die optimale Temperatur gebracht werden, sodass die Umwandlung in die kristalline Phase erfolgen kann.

Bevorzugt ist weiterhin vorgehen, dass durch die Strahlung in der/den amorphen Schicht(en) Temperaturen von über 200°C erzeugt werden, bevorzugt über 400°C, besonders bevorzugt über 600°C, noch weiter bevorzugt über 800°C, am bevorzugtesten über 1200°C. In diesen Temperaturbereichen kann vorteilhaft eine besonders effiziente Umwandlung in die kristalline Phase erfolgen.

Bevorzugt ist weiterhin vorgehen, dass die Einstrahlungszeit auf einem Punkt unter 30 s liegt, bevorzugt unter 15 s, besonders bevorzugt unter 1 s, ganz besonders bevorzugt unter 100 ms. In diesen Zeitbereichen ist eine Umwandlung in die kristalline Phase erreichbar, sodass eine erhebliche Reduzierung der Prozesszeiten erreichbar ist, da nur die amorphe(n) Schicht(en) bestrahlt werden.

Bevorzugt ist weiterhin vorgehen, dass eine Reflexion der Strahlung an Substratflächen und/oder Substratstapelflächen unter 4 % einer Ausgangsintensität einer Strahlungsquelle beträgt, bevorzugt unter 3 %, besonders bevorzugt unter 1%. Dadurch wird der Energieverlust beim Eintritt der Strahlung in das/die Substrat(e) minimiert, sodass die maximale Energie für die Umwandlung der amorphen Schicht(en) in die kristalline Phase genutzt werden kann.

Insbesondere wird mindestens eine Antireflexionsschicht und/oder mindestens eine Mottenaugenstruktur auf diejenige(n) Seite(n) des Substrats bzw. der Substrate aufgebracht, die der/den Bondoberfläche(n) gegenüberliegt/gegenüberliegen, wobei insbesondere eine Flüssigkeit und/oder ein Flüssigkeitsfilm zwischen der Strahlungsquelle und der Substratoberfläche angeordnet wird.

Die Transmission, das Verhältnis zwischen der Intensität an der Oberfläche, an der die Strahlung eintritt, und der Restintensität an der erfindungsgemäßen, amorphen Bondgrenzfläche, hängt gemäß dem Lambert-Beerschen Gesetz von der Länge des Transmissionspfades durch das Material und dem Absorptionskoeffizienten des Materials ab. Letzterer ist eine Funktion der Wellenlänge. Die genannten prozentuellen Transmissionswerte gelten daher vorzugsweise für alle Material/Dicken/Wellenlängenkombinationen in dem Sinne, dass erfindungsgemäß eine möglichst hohe Transmission durch die kristalline Phase des jeweils verwendeten Materials bei gegebener Dicke und Wellenlänge angestrebt wird.

Dadurch wird der Energieverlust beim Durchgang der Strahlung durch das/die Substrat(e) minimiert, sodass die maximale Energie für die Umwandlung der amorphen Schicht(en) in die kristalline Phase genutzt werden kann.

Hierbei liegt eine Schwankung der Transparenz in Abhängigkeit einer Wellenlänge der Strahlung unter 10%, weiter bevorzugt unter 5%, besonders bevorzugt unter 3%, ganz besonders bevorzugt unter 1%.

Bevorzugt ist weiterhin vorgehen, dass vor und/oder während der Bestrahlung eine Heizung mindestens eines der Substrate, bevorzugt beider Substrate, erfolgt, wobei das/die Substrat(e) über 25°C, bevorzugt über 150°C, besonders bevorzugt über 300°C geheizt werden. Durch die Heizung kann vorteilhaft die Umwandlung der mindestens einen amorphen Schicht in die kristalline Phase unterstützt und erleichtert werden.

Bevorzugt ist weiterhin vorgehen, dass die amorphe(n) Schicht(en) durch Amorphisierungsverfahren, insbesondere Ionenstrahlverfahren und/oder Plasmaverfahren, erzeugt wird/werden, wobei Teilchen, die auf das Substrat oder die Substrate treffen, Energien zwischen 0.01 eV und 1000 eV aufweisen, vorzugsweise zwischen 0,1 eV und 100 eV, noch bevorzugter zwischen 1 eV und 10 eV.

Die Eindringtiefe der Teilchen in die Substrate ist hierbei größer als 0 nm, bevorzugt größer als 5 nm, noch bevorzugter größer als 10 nm, am bevorzugtesten größer als 25 nm, am allerbevorzugtesten größer als 50 nm.

Bevorzugt ist/sind die Dicke(n) der amorphen Schicht(en) kleiner als 50 nm, bevorzugt kleiner 20 nm, besonders bevorzugt kleiner 10 nm, ganz besonders bevorzugt kleiner 5 nm, im optimalen Fall kleiner 2 nm, im Idealfall kleiner 1 nm. So kann vorteilhaft ein übergangsfreier Substratstapel geschaffen werden.

Bevorzugt ist die Variation der Schichtdicke(n) der amorphen Schicht(en) kleiner ist als 20 mal die Gitterkonstante der Substratkristalle, bevorzugt kleiner als 10 mal Gitterkonstante des Substratkristalls, besonders bevorzugt kleiner als 5 mal Gitterkonstante des Substratkristalls. Dadurch kann vorteilhaft eine gleichförmige amorphe Schicht erzeugt werden, wodurch die Kristallisierung erleichtert wird und ein übergangsfreier Substratstapel geschaffen werden kann.

Bevorzugt wird das erste Substrat und/oder das zweite Substrat vor dem Erzeugen der amorphen Schicht(en) zumindest teilweise von einer natürlichen Oxidschicht befreit werden. Somit werden störende Einflüsse von Oxiden beseitigt. Dadurch kann die Kristallisierung erleichtert und ein übergangsfreier Substratstapel geschaffen werden.

Bevorzugt wird/werden die amorphe(n) Schicht(en) durch folgende Verfahren erzeugt:
- Chemische Gasphasenabscheidung (CVD),
- Physikalische Gasphasenabscheidung (PVD),
- Plasmabehandlung oder
- Ionenstrahlbehandlung.

Ein Grundgedanke der Erfindung ist insbesondere, dass die Unterschiede in der Absorption von verschiedenen Phasen eines Substrats ausgenutzt werden, um vorwiegend die Bondgrenzfläche zu erwärmen. Mindestens ein Substrat kann dabei kristallin, insbesondere monokristallin sein. Mindestens eines der Substrate soll eine amorphe Schicht aufweisen.

Das, insbesondere kristalline, Substrat soll beziehungsweise die, insbesondere kristallinen, Substrate sollen eine niedrige Absorption, eine hohe Transmission und eine geringe Reflexion für die Strahlung besitzen. Die amorphe Schicht besitzt dafür eine hohe Absorption, niedrige Transmission und niedrige Reflexion für die Strahlung. Dadurch wird die Strahlung hauptsächlich in der Bondgrenzfläche (d.h. an den Bondgrenzflächen) umgesetzt.

Ein großer Teil der Strahlung wird in der amorphen Schicht beziehungsweise den amorphen Schichten absorbiert und in Wärme umgewandelt, sodass eine erhöhte thermische Bewegung der Atome in der amorphen Schicht beziehungsweise den amorphen Schichten zu einer Neuordnung der Atome führt. Insbesondere erfolgt eine Phasenumwandlung der amorphen Phase beziehungsweise Phasen in die kristalline Phase beziehungsweise Phasen an der Bondgrenzfläche.

Somit kann ein Substratstapel mit relativ perfektem, insbesondere monokristallinem, Gitter hergestellt werden. Das so entstehende Gitter kann zwar immer noch Versetzungen aufweisen, die das erzielte Resultat aber nicht wesentlich verschlechtern.

Der erfindungsgemäße Gedanke besteht insbesondere darin, dass ein mit Prebond verbondeter Substratstapel mittels Strahlung lokal so behandelt wird, dass der amorphe Zustand der Bondgrenzfläche und deren Umgebung in den kristallinen Zustand überführt werden. Dabei wird auch die Bondfestigkeit durch das Verschwinden der amorphen Bondgrenzfläche zwischen den beiden Substraten erhöht. Insbesondere werden durch die weitgehende Umwandlung in die kristalline Phase auch die elektrischen Eigenschaften der Bondgrenzfläche verbessert. Vorzugsweise kann dadurch z.B. ein überwiegend ohmscher Übergang gewährleistet werden. Dies bedeutet zum Beispiel, dass eine Schwellenspannung/Durchbruchspannung, eines Diodenanteils weniger als 10% des gesamten Spannungsabfalls am Übergang ausmacht.

Vorteilhaft für die Erfindung ist die Vereinfachung der Verfahren zum Bonden. Durch geeignete Materialpaarung sowie Materialverwendung des Substrats kann ein Bond ohne Fremdatom- oder Fremdionbelastung entstehen. Es werden homogene, höchstens bis auf einige Gitterdefekte, insbesondere Leerstellen und Versetzungen, perfekte Kristalle miteinander verbunden, sodass die elektrischen Eigenschaften weiter optimiert und verbessert werden.

Vorliegende Erfindung verwendet eine, insbesondere elektromagnetische, Strahlung, um die amorphe Bondgrenzfläche des Substratstapels mittels Phasenumwandlung in die kristalline Phase zu überführen und die Substrate des Substratstapels dadurch untrennbar miteinander zu verbinden.

Das erfindungsgemäße Verfahren verwendet bevorzugt die folgenden Verfahrensschritte:
- Herstellung einer amorphisierten Schicht an den zu bondenden Substratoberflächen,
- Reinigung der Substratoberflächen,
- Ausrichtung der Substrate zueinander,
- Prebond mittels Direktbonden,
- Erfindungsgemäße Laserbehandlung zur Entfernung der Bondgrenzfläche.

Der Erfindung liegt zugrunde, dass unterschiedliche Phasen in bestimmten Energiebereichen bzw. Wellenlängenbereichen ein sehr unterschiedliches Absorptionsvermögen aufweisen.

Bei bestimmten Wellenlängen und/oder Wellenlängenbereiche besitzen kristalline Phasen von Substratmaterialien einen hohen Transmissionsgrad, einen niedrigen Absorptionsgrad und einen niedrigen Reflexionsgrad. Somit kann eine Strahlung die kristalline Phase praktisch ungehindert passieren.

Bei denselben bestimmten Wellenlängen und/oder Wellenlängenbereichen besitzen amorphe Phasen von Substratmaterialien einen niedrigen Transmissionsgrad, einen hohen Absorptionsgrad und einen niedrigen Reflexionsgrad. Somit wird die Strahlung überwiegend von der amorphen Phase aufgenommen.

Die Aufnahme der Strahlung führt zu einer, insbesondere lokalen, gezielten Erwärmung der amorphen Phase. Eine Erwärmung ist identisch zu einer Erhöhung des Energiegehaltes bzw. zu einer Erhöhung der thermischen Bewegung. Es ist erfindungsgemäß möglich, einen so hohen thermischen Bewegungszustand in der amorphen Phase zu erreichen, dass eine Phasenumwandlung, insbesondere eine Kristallisation, stattfindet.

Erfindungsgemäß wird sich die amorphe Phase während und/oder nach dem Wärmeeintrag neu ordnen und daher kristallisieren. Diese Phasenumwandlung findet erfindungsgemäß in der amorphen Phase der Bondgrenzfläche statt. Der Energieeintrag führt dazu, dass das System über eine Schwellenenergie gebracht wird, die erforderlich ist, um Kristallisation zu ermöglichen. Die Gesamtenergie des kristallinen Systems ist aber geringer als die des amorphen Systems. Daher tendiert das System grundsätzlich zur kristallinen Struktur.

Somit führt eine lokale Phasenumwandlung, insbesondere Kristallisation der Bondgrenzfläche, zur Ausheilung der Bondgrenzfläche.

Die vorliegende Erfindung steuert bzw. regelt mittels Parametersätzen bzw. Rezepten die notwendigen physikalischen Effekte sowie Rahmenbedingungen, wobei Rezepte optimierte Wertesammlungen von Parametern sind, die im funktionalen oder verfahrenstechnischen Zusammenhang stehen. Die Nutzung von Rezepten erlaubt die Reproduzierbarkeit von Verfahren. Diese beinhalten:
- Material: Substratgeometrie mit Form- und Lagetoleranzen gemäß Semi-Normen und anderen Festlegungen, Ebenheiten sowie Welligkeiten der Substrate, Substratmaterial, Dotierungen, Amorphisierung, Schichtdicke der amorphen Schicht,
- Materialpaarung: Werden Substrate mit gleicher amorpher Schicht aber unterschiedlichem Material im Substratvolumen (engl. bulk) verbondet, oder sind die Substrate praktisch identisch miteinander.
- Substratvorbereitung: Sauberkeit von Substraten, Fremdatombelastung, Einlagerung atomarer Wasserschichten oder Gase auf der zu bondenden Flächen sowie in den Grenzschichten.
- Strahlungseintrag der Strahlung mit Wellenlänge, Einwirkdauer, Einfallswinkel.
- Umgebungsbedingungen für den Substratstapel: Temperatur, Atmosphäre.

Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben. Es sollen nicht kreisrunde Substrate (insbesondere Viereck-Paneele, Waferbruchstücke) ebenfalls gehandhabt werden.

Im weiteren Verlauf wird die Ebenheit als Maß für die Perfektion einer planaren Fläche, insbesondere einer Oberfläche, verwendet. Abweichungen von einer planaren Oberfläche ergeben sich durch Welligkeiten und Rauigkeiten. Die Welligkeit einer Oberfläche zeichnet sich durch eine gewisse periodische Anhebung und Absenkung der Oberfläche, insbesondere im Millimeterbereich, seltener im Mikrometerbereich, ab. Rauigkeit hingegen ist ein eher aperiodisches Phänomen im Mikro- bzw. Nanometerbereich. Die genaue Definition derartiger Oberflächeneigenschaften ist jedem Fachmann der Oberflächenphysik-, Tribologie, des Maschinenbaus oder der Werkstoffwissenschaften bekannt.

Die Substratoberfläche sowie deren Abweichung von einer mathematischen Ebene kann als eine Überlagerung von Welligkeit und Rauheit betrachtet werden. Es ist erfindungsgemäß vorteilhaft, dass die zu bondenden Oberflächen eine minimale Abweichung von der perfekten, mathematischen Ebene aufweisen. Um die unterschiedlichen Abweichungen von der idealen Oberfläche zu behandeln, wird im weiteren Verlauf der Patentschrift der Begriff der Rauheit synonym für die Überlagerung aller derartigen Effekte verwendet. Die Rauheit wird entweder als mittlere Rauheit, quadratische Rauheit oder als gemittelte Rautiefe angegeben. Die ermittelten Werte für die mittlere Rauheit, die quadratische Rauheit und die gemittelte Rautiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rautiefe zu verstehen. Die Rauheit ist dabei kleiner als 100 nm, vorzugsweise kleiner als 10 nm, noch bevorzugter kleiner als 5nm, am bevorzugtesten kleiner als 3 nm, am allerbevorzugtesten kleiner als 2 nm.

Substratwerkstoffe können sowohl handelsübliche Wafer sein, also Elementhalbleiter, Verbindungshalbleiter sowie organische Halbleiter.

Hauptsächlich werden hier jedoch Halbleiter, welche Elemente wie Silizium, und/oder Germanium, und/oder Kohlenstoff und/oder Tellur und/oder Aluminium und/oder Indium und/oder Gallium beinhalten, insbesondere als Hauptkomponente beinhalten, angewendet.

Neben dem Substratmaterial, welches insbesondere für die verwendete Strahlung möglichst transparent sein soll, können andere Materialien verwendet werden um die physikalischen Eigenschaften des Substratmaterials zu beeinflussen. Sofern die Materialien im Substratmaterial gelöst werden, handelt es sich um eine Lösung, im ppm (parts per million) Bereich auch als Dotierung bezeichnet.

Dotierungen beeinflussen die elektronischen sowie elektromagnetischen Eigenschaften der Substrate. Dementsprechend haben Dotierungen einen Einfluss auf das Substratmaterial, deren Transparenz sowie deren Absorption. Es ist weiterhin denkbar, mit Hilfe von Dotierungen entsprechende Sollbruchstellen in dem Substrat zu erzeugen.

Amorphisierung ist eine Phasenumwandlung eines geordneten Kristalls in eine amorphe Phase. Amorphe Phasen werden auch als Glasphasen bezeichnet. Bei dieser Definition ist die bei einigen Materialfamilien beobachtbare Glasübergangstemperatur unerheblich: Zur Unterscheidung einer kristallinen Phase von einer amorphen Phase verwendet man im Allgemeinen einen Ordnungsparameter. Ein Ordnungsparameter ist beispielsweise beschrieben in: Schmidt, Rainer, "Werkstoffverhalten in biologischen Systemen", (1999), p. 58, doi: 10.1007/978-3-642-60074-6*.* Man erkennt, dass es nötig sein kann, einen Ordnungsparameter abhängig vom verwendeten Festkörper zu definieren, sodass keine allgemeine Strategie zu dessen Definition angegeben werden kann. Der Wert des Ordnungsparameters wird Ordnungsgrad genannt. Im Allgemeinen werden vollständig kristalline Phasen mit einem Ordnungsgrad von 1 beschrieben. Amorph wird als eine weitgehend ungeordnete Phase mit einem Ordnungsgrad kleiner 0,5 bevorzugt kleiner 0,2, besonders bevorzugt kleiner 0,1 verstanden. Eine vollständig amorphe Phase besitzt den Ordnungsgrad 0. In sehr vielen Fällen kann zur Definition des Ordnungsparameters auch die Landau-Theorie verwendet werden. Das Ziel der Amorphisierung ist die Herstellung einer vollständig geschlossenen, ungeordneten Schicht deren Oberfläche in weiteren Prozessschritten zur Verbesserung eines Bondprozesses beiträgt.

Es existieren zwei grundlegende Verfahrensarten um eine Amorphisierung an einer Substratoberfläche zu erzeugen.

In einer ersten Methode werden hochenergetische Teilchen auf die Substratoberfläche geschossen, welche ein, insbesondere kristallines, Gefüge amorphisieren. Diese Verfahren werden im weiteren Verlauf als Amorphisierungsverfahren bezeichnet. Beispiele für Amorphisierungsverfahren sind Ionenstrahlverfahren und Plasmaverfahren.

In einer zweiten Methode, die jedoch nicht zum Gegenstand der beanspruchten Erfindung gehört, werden Materialien auf dem Substratmaterial abgeschieden. Dabei sind Material und Substratmaterial vorzugsweise identisch. Diese Verfahren werden im weiteren Verlauf als Abscheideverfahren bezeichnet. Beispiele für Abscheideverfahren sind chemische Gasphasenabscheidung (engl.: chemical vapour deposition, CVD) und physikalische Gasphasenabscheidung (engl.: physical vapour deposition, PVD).

Bei einem Amorphisierungsverfahren besitzen die Teilchen die auf die Substratoberfläche einschlagen Energien zwischen 0.01 eV und 1000 eV, vorzugsweise zwischen 0.1 eV und 100 eV, noch bevorzugter zwischen 1 eV und 10 eV. Die Eindringtiefe der Teilchen in das Substratmaterial ist größer als 0 nm, bevorzugter größer als 5 nm, noch bevorzugter größer als 10 nm, am bevorzugtesten größer als 25 nm, am allerbevorzugtesten größer als 50 nm.

Die Dicke der amorphen Schicht ist kleiner 50 nm, bevorzugt kleiner 20 nm, besonders bevorzugt kleiner 10 nm, ganz besonders bevorzugt kleiner 5 nm, im optimalen Fall kleiner 2 nm, im Idealfall kleiner 1 nm.

Mit dem erfindungsgemäßen Verfahren können Substrate aus dem gleichen Material oder mit unterschiedlichen Materialien miteinander verbunden werden. Die Substrate verfügen vorzugsweise über funktionale Einheiten, Leiterbahnen, TSVs, Bondinseln (engl.: pads) Bei den erfahrungsgemäßen Substraten handelt es sich um Hybridsubstrate. Unter einem Hybridsubstrat versteht man ein Substrat, das an der Oberfläche aus einem Dielektrikum besteht, welches elektrisch leitende Bereiche, insbesondere Bondinseln und TSVs, umschließt. Das erfindungsgemäße Verfahren wird explizit für das Bonden von Hybridsubstraten offenbart. Hierbei werden mit Hilfe des erfindungsgemäßen Verfahrens die elektrisch leitenden Bereiche amorphisiert.

Die Oberfläche des Dielektrikums wird zum Prebonden verwendet. Die amorphisierten elektrisch leitenden Bereiche kontaktieren und werden mit Hilfe des erfindungsgemäßen Verfahrens vom amorphen in den Kristallinen Zustand übergeführt.

Insbesondere können Substrate unterschiedlicher Materialien mit identischen amorphen Schichten miteinander gebondet werden. Dabei werden, höchstens bis auf Versetzungen und Korngrenzen, perfekte Übergänge in der Bondgrenzfläche erzeugt. Dieses Verfahren ermöglicht eine Verbindung von unterschiedlichen Materialien, insbesondere von Halbleitern, und die Herstellung von Materialübergängen, insbesondere von Halbleiterübergängen.

Weiterhin kann mit dem erfindungsgemäßen Verfahren ein mit Einzelbauteilen, insbesondere mit Chips, bestücktes Substrat (engl. Chip to wafer bond) gebondet werden.

Weiterhin können mit dem erfindungsgemäßen Verfahren Chips miteinander gebondet werden. Insbesondere können dabei zwei mit Einzelbauteilen bestückte, insbesondere durchsichtige, Substrate als Träger verwendet werden.

Die Sauberkeit der Substratoberflächen reduziert die Einlagerung von Fremdatomen in die Bondgrenzfläche, was die Leistungsfähigkeit des finalen Produktes steigert, da dadurch Störeinflüsse reduziert werden.

Somit soll die Sauberkeit der Substratoberflächen, insbesondere der zu bondenden Oberflächen ebenfalls charakterisiert werden. Die Fremdatombelastung der zu bondenden Oberflächen soll insbesondere pro cm² aus einem Material mit jeweils weniger als 50 x 10¹⁰, vorzugsweise jeweils weniger als 5 x 10¹⁰, Atomen der chemischen Elemente Ca, Cr, Co, Cu, Fe, K, Mn, Mo, Na, Ni, Ti und jeweils weniger als 20 x 10¹¹, vorzugsweise jeweils weniger als 1 x 10¹¹, Atomen der chemischen Elemente AI, V, Zn beinhalten. Mögliche Nachweismethoden sind
- Atomabsorptionsspektrometrie (AAS)
- Atomemissionsspektrometrie (AES)
- Energiedispersive Röntgenspektroskopie (EDX)
- Wellenlängendispersive Röntgenspektroskopie (WDX)
- Funkenspektrometrie (OES)
- Fluoreszenzmethoden
   ∘ Atomfluoreszenzspektroskopie (AFS)
   ∘ Röntgenfluoreszenzanalyse (XRF)

Die Partikelbelastung mit Fremdpartikeln ist für Substrate mit 200 mm Durchmesser für Partikel mit einer Messempfindlichkeit von 0,2 Mikrometer kleiner als 100 Teilchen, bevorzugt kleiner 75 Teilchen, besonders bevorzugt kleiner 60 Teilchen.

Die Partikelbelastung mit Fremdpartikeln ist für Substrate mit 300 mm Durchmesser für Partikel mit einer Messempfindlichkeit von 0,2 Mikrometer kleiner als 200 Teilchen, bevorzugt kleiner 150 Teilchen, besonders bevorzugt kleiner 115 Teilchen.

Eine reduzierte, insbesondere minimierte, Partikelbelastung der zu bondenden Oberflächen führt zu einem besseren Prebond, welcher die elektronischen Eigenschaften des erfindungsgemäß hergestellten fertigen Produktes verbessert.

Weiterhin kann die zu bondende Oberfläche in normaler Reinraumatmosphäre bei Raumtemperatur mit mindestens einer Monolage Wasser sowie Monolagen der Gase der Luftbestandteile benetzt sein. Um diese Komponenten zu entfernen ist ein Ausheizen über 100°C im Vakuum bei 1 bar, vorzugsweise bei weniger als 0.5 bar, noch bevorzugter bei weniger als 0.1 mbar, am bevorzugtesten bei weniger als 0.01 mbar, am allerbevorzugtesten bei weniger als 0.001 mbar und Aufbewahrung in einem evakuierten Transportbehälter oder Vorrichtung vorgesehen.

Ein weiterer Verfahrensparameter des erfindungsgemäßen Verfahrens ist die Beschaffenheit der Strahlung. Die Strahlung wird in den amorphen Schichten absorbiert und bewirkt dadurch die Phasenumwandlung. Für die Auswahl der Strahlungsquelle werden die Wellenlänge sowie die Intensität als Parameter verwendet. Grob unterteilt kann die Strahlung bzw. deren Quelle als Breitbandstrahler oder als monochromatischer Strahler verwendet werden. Ein Breitbandstrahler bzw. der monochromatische Strahler, insbesondere Laser, strahlt im Energiebereich zwischen 1 eV und 10E8 eV, vorzugsweise zwischen 1 eV und 10E6 eV, noch bevorzugter zwischen 1 eV und 10E4 eV, am allerbevorzugtesten zwischen 1eV und 10 eV.

Die Strahlungsleistung der Strahlungsquelle liegt zwischen 0.01 Watt und 10000 Watt, vorzugsweise zwischen 0.1 Watt und 1000 Watt, am allerbevorzugtesten zwischen 1 Watt und 100 Watt.

Die Strahlung kann mittels optischer Elemente wie beispielsweise Spiegel, Linsen, Prismen geformt/gelenkt werden. Die Strahlung kann zu einer Strahlungsfläche mit homogener Strahlungsverteilung geformt werden, wobei die Fläche an den zu bestrahlenden Substratstapel angepasst wird, oder durch eine Linienquelle und/oder eine Punktquelle mit hoher Leistung und einem Strahlungsquerschnitt von kleiner 5 mm², bevorzugt kleiner 3 mm², besonders bevorzugt kleiner 1 mm² am Eintreffpunkt der Strahlung gemessen, erzeugt werden.

Insbesondere sind mittels Strahlung lokal begrenzte Temperaturen über 200°C, bevorzugt über 400°C, besonders bevorzugt über 600°C, im optimalen Fall über 800°C, im Idealfall über 1200°C in der amorphen Phase zur Phasenumwandlung erreichbar.

In Abhängigkeit der thermischen sowie optischen Parameter der umzuformenden amorphen Bondgrenzfläche ist die Einstrahlungszeit ein Regelparameter für die Wirkung der Strahlung. Dabei kann die Einstrahlungszeit, insbesondere bei unbewegtem Substratstapel, unter 30 s, bevorzugt unter 15 s, besonders bevorzugt unter 1 s, ganz besonders bevorzugt unter 100 ms betragen. Der Effekt der Phasenumwandlung hängt von der Einstrahlungszeit und deren Wirkungsgrad auf die amorphe Phase in der Bondgrenzfläche ab, sodass die Zeit als Integralfaktor betrachtet wird.

Insbesondere soll die Strahlung normal (also unter einem Winkel von 90°), d.h. senkrecht auf die Bondgrenzfläche eintreffen, wobei eine Schwankung des Einfallswinkels um weniger als +/- 5 Grad, bevorzugt weniger als +/- 3 Grad, besonders bevorzugt weniger als +/- 1 Grad zulässig ist. Bei flacheren Einfallswinkeln wird die Reflexionskomponente der Strahlung größer, sodass ein nahezu verlustfreier Energieeintrag nicht gewährleistet ist.

Erfindungsgemäß beeinflussen die Parameter Substrattemperatur sowie Atmosphäre den physikalischen Effekt der Phasenumwandlung. Für die Reaktion notwendige Energie wird in allgemeine Wärmeeinwirkung mittels Konduktionstemperierung (Heizung oder Kühlung), Konvektionstemperierung und Strahlungstemperierung unterteilt. Eine Substratheizung erhöht die allgemeinen thermischen Gitterschwingungen im Kristall sowie der Atome in der amorphen Phase, sodass eine zusätzliche Heizung zur Strahlung die Reaktion beschleunigt und entsprechend vorteilhaft ist.

Eine Kühlung und/oder Temperierung ist für die Reaktionsgeschwindigkeiten der Phasenumwandlung von Bedeutung, da mittels Temperierung eine ausreichende Keimbildung begünstigt wird, sowie die Fehlerstellen Zeit zum Ausheilen der Defekte bekommen. Mit anderen Worten wird der thermische Gradient zwischen Substratvolumen und aufgeheizter Stelle in der amorphen Phase über die zusätzliche Variable der Umgebungs- sowie Substrattemperierung besser steuerbar bzw. regelbar. Somit lassen sich Temperierungsverläufe optimal ausführen. Je kleiner der thermische Gradient im Substratstapel gehalten wird, desto spannungsarmer wird das fertiggestellte Produkt. Bei der Temperierung werden die Unterschiede in den thermischen Ausdehnungskoeffizienten (sowohl linear als auch im Volumen) bzw. in den thermischen Ausdehnungen beachtet und mit rechnerunterstützter Regelung der Temperaturverlauf soweit korrigiert, dass das Produkt thermisch und mechanisch einen niedrigen Spannungszustand aufweist.

Die Temperierung soll weniger als +/- 5 Grad, bevorzugt weniger als +/- 3 Grad, im Optimalfall weniger als +/- 0,1 Grad von der jeweiligen gesetzten Temperatur abweichen.

Ein wesentlicher Vorteil des erfindungsgemäßen Verfahrens besteht darin, dass durch die lokale Erwärmung der amorphen Bereiche die thermische Dehnung ebenfalls nur auf lokale Bereiche beschränkt wird. Die thermische Dehnung ist vor allem dann von Relevanz, wenn Substrate unterschiedlicher Materialien miteinander verbunden werden sollen, deren thermische Ausdehnungskoeffizienten stark voneinander abweichen. Die Tabelle 1 listet einige typische Halbleitermaterialien und deren thermische Ausdehnungskoeffizienten bei Raumtemperatur auf.

Tabelle 1 zeigt die ungefähren thermischen Ausdehnungskoeffizienten α bei Raumtemperatur für unterschiedliche Materialien die typischerweise in der Halbleiterindustrie verwendet werden. Die angegebenen Werte der thermischen Ausdehnungskoeffizienten sind ungefähre Richtwerte und schwanken abhängig von der jeweiligen genannten Quelle. Die genannten Materialien gehören alle dem kubische Kristallsystem an, wodurch ihre thermische Ausdehnung isotrop ist.

**Tabelle 1**

| Al | Ge | Au | Ag | Cu | InP | InSb | InAs | Si | AlN | GaAs | GaP | GaSb |
|---|---|---|---|---|---|---|---|---|---|---|---|---|
| α in 10⁻⁶ K⁻¹ | | | | | | | | | | | | |
| 23,1 | 5,8 | 14,2 | 18,9 | 16,5 | 4,75 | 5,37 | 4,52 | 2,6 | 4,5 | 5,8 | 4,5 | 7,75 |

Der Unterschied in den thermischen Ausdehnungskoeffizienten zwischen zwei Materialien kann durch das erfindungsgemäße Verfahren nicht eliminiert werden, allerdings kann die thermische Dehnung auf extrem kleinen Bereich beschränkt werden. Werden zwei Hableitermaterialien mit stark unterschiedlichen thermischen Ausdehnungskoeffizienten miteinander verbondet, so wird unmittelbar in der Nähe der amorphen Schicht, die mit Hilfe des erfindungsgemäßen Effekts in eine kristalline Schicht umwandelt, eine thermische Dehnung entstehen, allerdings wird diese mit zunehmender Entfernung von der Bondgrenzfläche rasch abnehmen. Es entsteht daher ein sehr starker Dehnungs- bzw. Spannungsgradient. Mit besonderem Vorzug wird die in die Bondgrenzfläche eingebrachte Energie sogar nur dazu verwendet, den Übergang vom amorphen in den kristallinen Zustand durchzuführen, ohne eine nennenswerte Erwärmung der Bondgrenzfläche durchzuführen. Dadurch wird der Temperaturgradient minimiert und damit auch die thermischen Dehnungen bzw. Spannungen. Dies kann vorzugsweise durch einen gepulsten Laserbetrieb erfolgen.

In einer erfindungsgemäßen Ausführungsform ist eine Temperierung des Substratstapels über 100°C, bevorzugt über 200°C, besonders bevorzugt über 300°C von Vorteil, damit die thermischen Spannungen im Substrat durch die Phasenumwandlung durch die höhere Beweglichkeit des kristallinen Gitters reduziert werden. Somit lassen sich vor allem brüchige Substratwerkstoffe in thermodynamisch langsam ablaufenden Verfahren spannungsfrei verbinden.

Das erfindungsgemäße Verfahren wird in einer bevorzugten Ausführungsform im Vakuum bei weniger als 1 bar, vorzugsweise weniger als 0.1 mbar, noch bevorzugter weniger als 0.01 mbar, am bevorzugtesten weniger als 0.001 mbar, am allerbevorzugtesten weniger als 0.0001 mbar durchgeführt. Somit kann insbesondere die Bondgrenzfläche mit einer Monolage Gas einer festgelegten Atmosphäre belegt werden, mit welcher die Fremdatome als eine Dotierung in die amorphe Phase eingebracht werden können.

In einer anderen Ausführungsform kann eine evakuierte Vorrichtung eine Anlagerung von Fluiden (Gase oder Flüssigkeiten sowie deren Dämpfe) verhindern oder verlangsamen. Somit kann eine oxidierungsfreie Schicht hergestellt, also amorphisiert werden. Weiterhin kann ein Substratstapel ohne Unterbrechung des Vakuums gebondet werde. Weiterhin kann der vorgebondete Substratstapel ohne Unterbrechung des Vakuums thermisch, insbesondere mittels Strahlung erfindungsgemäß nachbehandelt werden. Dementsprechend wird die Bondgrenzfläche erfindungsgemäß mindestens reduziert, bevorzugt vollständig eliminiert.

Der Vorteil der Ausführung im Vakuum ist, dass selbst die Randzonen des Substratstapels ohne Einwirkung der Atmosphäre gebondet werden, sodass eine Verbesserung der Homogenität der Bondgrenzfläche bewirkt wird.

Erfindungsgemäß ist das Absorptionsvermögen der Substratoberfläche in der Bondgrenzfläche für die Strahlung größer als das Absorptionsvermögen des Substratvolumens.

Bevorzugt besteht das Substratvolumen zumindest mehrheitlich aus kristallinen Phasen, insbesondere aus einer einkristallinen Phase, des Substratmaterials.

Da sich eine Strahlungsintensität an einem Werkstück aus Reflexion, Absorption und Transmission zusammensetzt, sollen Reflexion und Transmission ebenfalls beachtet werden. Für das erfindungsgemäße Verfahren ist von besonderer Bedeutung, die Reflexion an den Substratflächen und Substratstapelflächen unter 4 %, bevorzugt unter 3 %, besonders bevorzugt unter 1% der Ausgangsintensität der Strahlungsquelle zu begrenzen. Dazu können technische Maßnahmen zur Oberflächenveredelung wie Antireflexionsschichten und/oder Mottenaugenstrukturen an die der bondenden Seite gegenüberliegende Substratoberfläche aufgebracht werden. Weiterhin kann die Einkoppelung der Strahlung und die Vermeidung von Reflexen mittels Flüssigkeit und/oder Flüssigkeitsfilm zwischen Strahlungsquelle und Substratoberfläche begünstigt werden.

Die Transparenz der kristallinen Phasen kann in Abhängigkeit der Wellenlänge der Strahlungsquelle einer Schwankung von 10%, bevorzugt 5%, besonders bevorzugt 3%, ganz besonders bevorzugt 1% unterliegen. Dies ist ein Materialparameter, also ist eine Abstimmung der Strahlungsquelle auf das jeweilige Substratmaterial vorgesehen.

### Verfahren

Im Folgenden wird ein beispielhafter Verfahrensablauf beschrieben, der jedoch nicht Teil der Erfindung wie beansprucht ist.

In einem ersten (optionalen) Verfahrensschritt werden zwei Substrate, ein erstes Substrat und ein zweites Substrat gereinigt und/oder vorbehandelt und/oder zumindest teilweise von einer natürlichen Oxidschicht befreit.

In einem zweiten Verfahrensschritt wird ein erstes kristallines, insbesondere monokristallines, Substrat mittels einer

Oberflächenbehandlung mit einer amorphen Schicht versehen. Dabei können Aufwachsprozesse wie CVD oder abrasive Verfahren, insbesondere eine Plasmabehandlung oder eine Ionenstrahlbehandlung verwendet werden. Die amorphe Schicht kann also entweder aufgebracht werden oder aus der Oberfläche des Substrats entstehen. Optional kann auch auf beiden Substraten eine amorphe Schicht erzeugt werden.

In einem dritten (optionalen) Verfahrensschritt werden die Substrate zueinander ausgerichtet.

In einem vierten Verfahrensschritt werden die Substrate zu einem Substratstapel gebondet. Danach kann optional eine Kontrolle der Ausrichtung des vorgebondeten Substratstapels erfolgen.

In einem fünften Verfahrensschritt wird mit einer Strahlung die amorphe Bondgrenzfläche in eine kristalline Phase verwandelt. Die amorphe Phasenmenge ist daher nach dem Verfahrensschritt kleiner als 50%, vorzugsweise kleiner als 40%, noch bevorzugter kleiner als 20%, am bevorzugtesten kleiner als 10%, am allerbevorzugtesten 0%. Die kristalline Phasenmenge ist entsprechend nach dem Verfahrensschritt größer als 50%, vorzugsweise größer als 60%, noch bevorzugter größer als 80%, am bevorzugtesten größer als 90%, am allerbevorzugtesten 100%. Insbesondere erfolgt somit eine vollständige Umwandlung der amorphen Phase in eine kristalline Phase. Die kristalline Phase kann nach dem Verfahrensschritt über Kristalldefekte wie interstitielle und/oder substitutionelle Atome, Leerstellen, Stufenversetzungen, Schraubenversetzungen etc. verfügen.

In einem sechsten, optionalen, Verfahrensschritt wird der fertiggestellte Substratstapel auf Bonderfolg mittels bildgebenden Verfahren wie Mikroskopie auf Fehler sowie unvollständige Phasenumwandlung untersucht.

Weitere Vorteile, Merkmale und Einzelheiten der Erfindung ergeben sich auch aus der nachfolgenden Beschreibung bevorzugter Ausführungsbeispiele sowie anhand der Zeichnungen. Diese zeigen in:
- Fig. 1a: eine schematische Prinzipdarstellung von zwei zu bondenden Substraten,
- Fig. 1b: eine schematische Prinzipdarstellung von zwei zu bondenden Substraten nach einer Amorphisierung der zu bondenden Oberflächen,
- Fig. 1c: zeigt eine schematische Prinzipdarstellung der Ausrichtung von zwei zu bondenden Substraten
- Fig. 1d: zeigt einen mit Prebond gebondeten Substratstapel in einer schematischen Prinzipdarstellung, welche aus den zwei zu bondenden Substraten entstanden ist
- Fig. 1e: zeigt die Einwirkung einer Strahlung auf die amorphen Schichten eines Substratstapels als eine schematische Prinzipdarstellung, wobei die Darstellung nicht maßstabsgetreu ist,
- Fig. 1f: zeigt den komplett wärmebehandelten Substratstapel in einer schematischen Prinzipdarstellung,
- Fig. 2: zeigt eine schematische Prinzipdarstellung, von drei Substraten, welche mit dem Verfahren gebondet werden können,
- Fig. 3: ein berechnetes Absorptionsspektrum für amorphes und kristallines Silizium,
- Fig. 4: ein Diagramm des Brechungsindex als Funktion der Teilchenenergie für amorphes und kristallines Silizium,
- Fig. 5a: schematisch einen Substratstapel mit amorphen Schichten,
- Fig. 5b: schematisch einen Substratstapel während einer Bestrahlung und
- Fig. 5c: schematisch einen Substratstapel mit kristallinen Strukturen.

In den Figuren sind gleiche Bauteile oder Bauteile mit der gleichen Funktion mit den gleichen Bezugszeichen gekennzeichnet. Die Figuren sind nicht maßstabsgetreu.

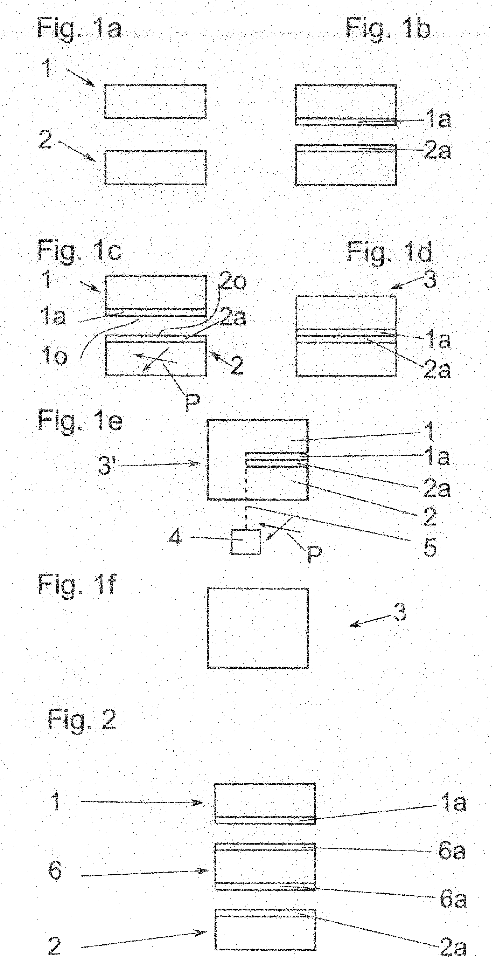

Fig. 1a zeigt eine nicht maßstabsgetreue, schematische Prinzipdarstellung von zwei zu bondenden Substraten 1, 2. Ein erstes Substrat 1 und ein zweites Substrat 2 werden in einem ersten optionalen Verfahrensschritt vorbehandelt. Die Vorbehandlung kann eine Reinigung der Substrate von chemischen und/oder physikalischen Verunreinigungen, beispielsweise von Partikeln umfassen. Weiterhin kann ein vorhandenes Oxid, insbesondere nasschemisch und/oder trockenchemisch, insbesondere in einer entsprechenden Vakuumanlage mit Substratprozessierung, entfernt werden. Fig. 1a zeigt einen ersten Verfahrensschritt eines beispielhaften Verfahrens.

Bei den Figuren werden zur besseren Übersicht Substrathalter, Vakuumkammer, Greifer, Pre- sowie Postprozessierungsvorrichtungen der Substratbearbeitungsvorrichtung samt Regelung, Energie- und Medienversorgung nicht dargestellt.

Fig. 1b zeigt eine nicht maßstabsgetreue, schematische Prinzipdarstellung der Substraten 1,2 nach einer Amorphisierung der zu bondenden Oberflächen. Das erste Substrat 1 wird in einer nicht dargestellten, Vorrichtung mit einer ersten dünnen amorphisierten Schicht 1a versehen und das zweite Substrat 2 wird in der nicht dargestellten, Vorrichtung mit einer zweiten dünnen amorphisierten Schicht 2a versehen. Fig. 1b ist ein zweiter Verfahrensschritt eines beispielhaften Verfahrens. Denkbar wäre alternativ, dass auf eine der beiden amorphisierten Schichten 1a, 2a verzichtet wird.

Fig. 1c zeigt eine nicht maßstabsgetreue, schematische Prinzipdarstellung der Ausrichtung der zu bondende Substrate 1, 2. Das erste Substrat 1 mit der ersten amorphen Schicht 1a wird relativ zu dem zweiten Substrat 2 mit der zweiten amorphen Schicht 2a zueinander so ausgerichtet, dass die amorphen Schichten 1a, 2a an einander zugewandten Oberflächen 1o, 2o der amorphen Schichten 1o 2o liegen. Eine Ausrichtungsvorrichtung ist hiermit ausdrücklich offenbart, wird jedoch nur symbolisch mit Bewegungsrichtungspfeilen P dargestellt. Fig. 1c ist ein dritter Verfahrensschritt eines beispielhaften erfindungsgemäßen Verfahrens.

Fig. 1d zeigt einen mit einem Prebond gebondeten Substratstapel 3 in einer nicht maßstabsgetreuen, schematischen Prinzipdarstellung, welcher aus den zwei zu bondenden Substraten 1 sowie 2 entstanden ist. Die amorphen Schichten 1a und 2a wurden mittels dem Prebond miteinander verbunden.

Fig. 1d zeigt einen vierten Verfahrensschritt.

Fig. 1e zeigt eine Einwirkung einer Strahlung 5 auf die amorphen Schichten 1a und/oder 2a des Substratstapels 3, welcher aus den Substraten 1,2 gebildet wurde. Eine Strahlungsquelle 4 erzeugt die Strahlung 5. Die Pfeile symbolisieren eine Relativbewegung zwischen Strahlungsquelle 4 und Substratstapel 3. Insbesondere kann die Strahlung 5 den Substratstapel 3 rasterförmig abfahren. In einer anderen Ausführungsform kann die Bewegungstrajektorie der Relativbewegung einer Regelung und/oder Steuerung, insbesondere in einem nicht dargestellten Steuerungsrechner gespeichert und als Rezept umgesetzt werden. So lassen sich optimale Bahnkurven für die minimierte Wärmebelastung von Substratregionen mit temperaturempfindlichen Zonen erzeugen. Die Modellierung und/oder Berechnung der Trajektorie kann aufgrund von Simulationen wie FEM oder gekoppelte thermischmechanische Modellbildung erfolgen. So können alle früher erwähnten Parameter zur Festlegung und/oder Anpassung der Einstrahlungszeit, Einstrahlungsort und Einstrahlungsbahn und Einstrahlungsintensität der Strahlung verwendet werden. Fig. 1e zeigt einen fünften Verfahrensschritt.

Fig. 1f zeigt den wärmebehandelten Substratstapel in einer schematischen Prinzipdarstellung, wobei die Darstellung nicht maßstabsgetreu ist. Dabei wurde beim durchgeführten fünften Verfahrensschritt die gesamte Bondgrenzfläche bzw. die gesamte amorphe Phase in eine kristalline Phase umgewandelt. Somit ist der Substratstapel untrennbar permanent gebondet.

Fig. 2 zeigt eine schematische Prinzipdarstellung, von drei Substraten 1, 2, 6, welche mit dem Verfahren in einer anderen Ausführungsform gebondet werden, wobei die Darstellung nicht maßstabsgetreu ist. Ein erstes Substrat 1 sowie ein zweites Substrat 2 erhalten jeweils zumindest eine amorphe Schicht 1a, 2a. Ein drittes Substrat 6, bei dem das Substratmaterial nicht für die Strahlung transparent sein muss, besitzt zwei amorphe Schichten 6a. Nach Fügen der Substrate 1 sowie 2 zum Substrat 6 kann eine Phasenumwandlung beidseitig zeitgleich oder zeitlich verschoben einen nicht dargestellten Substratstapel aus mehr als zwei Substraten erzeugen. Zweckmäßig lässt sich ein Substratstapel dabei aus drei Substraten, bevorzugt aus vier Substraten, besonders bevorzugt aus mehr als fünf Substraten mit dem offenbarten Verfahren herstellen.

Die folgenden Diagrammbeschreibungen zeigen anhand berechneter Daten das Absorptions- und Brechungsindexverhalten von amorphem und kristallinem Silizium. Die beiden Diagramme gelten als exemplarisches Beispiel für alle anderen Materialien, die in gewissen Wellenlängenbereichen dasselbe Verhalten wie Silizium zeigen.

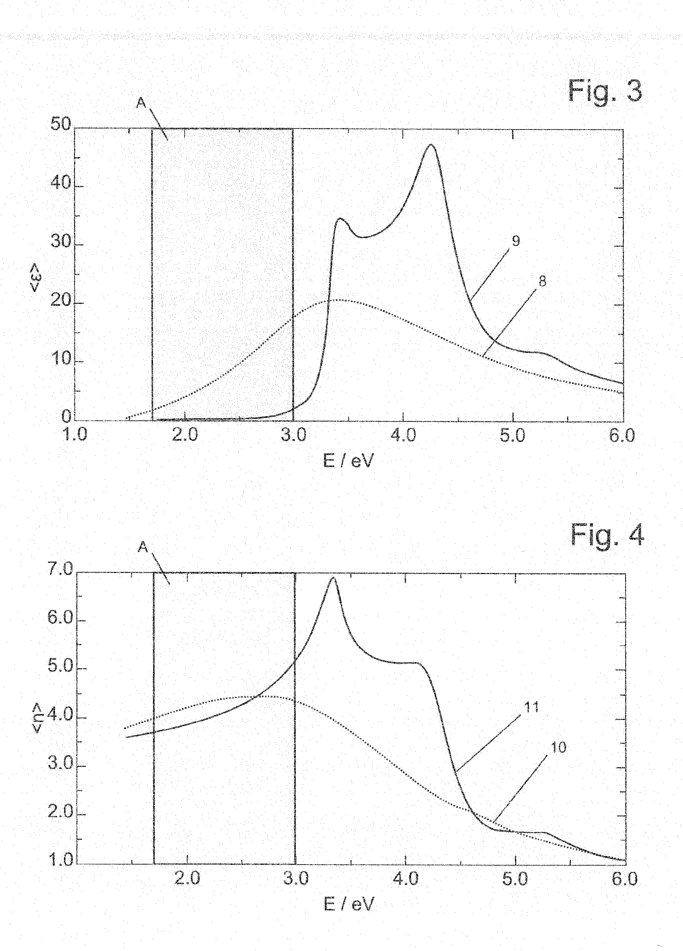

Fig. 3 zeigt zwei berechnete Absorptionsspektren für amorphes (gepunktete Linien 8) und kristallines (durchgezogene Linie 9) Si. Das Diagramm zeigt den Absorptionsindex ε als Funktion der Teilchenenergie, insbesondere Photonenenergie in eV. Die durchgezogene Linie 9 stellt das Absorptionsverhalten von Si in der kristallinen Phase in Abhängigkeit der Teilchenenergie dar. Die gepunktete Linie 8 stellt das Absorptionsverhalten von Si in der amorphen Phase in Abhängigkeit der Teilchenenergie dar. Im Teilchenenergiebereich A zwischen ca. 1.8 eV und 3.0 eV erkennt man, dass die amorphe Phase ein um den Faktor 0.2 - 18 höheres Absorptionsvermögen besitzt als die kristalline Phase. Teilchen die eine Teilchenenergie zwischen 1.8 eV und 3.0 eV besitzen werden von der kristallinen Phase kaum, von der amorphen Phase sehr stark, absorbiert.

Das offenbarte Verfahren nutzt also Bereiche des Spektrums aus, bei welchen die Absorption der amorphen Phase größer, insbesondere mindestens 1.1 mal größer, bevorzugt 2 mal größer, noch bevorzugter mehr als 5 mal größer, am bevorzugtesten mehr als 10 mal größer, am allerbevorzugtesten mehr als 20 mal größer als die Absorption der kristallinen Phase ist.

Fig. 4 zeigt zwei berechnete Brechungsindexgraphen 10, 11 für amorphes (gepunktete Linie 10) und kristallines (durchgezogene Linie 11) Si. Das Diagramm zeigt den Brechungsindex n als Funktion der Teilchenenergie eV, insbesondere Photonenenergie. Im Teilchenenergiebereich A zwischen ca. 1.8 eV und 3.0 eV erkennt man, dass die Brechungsindices n von amorphem und kristallinem Si sehr ähnlich sind. Alle physikalischen Prozesse, die ausschließlich auf dem Brechungsindex beruhen sind also in diesem Teilchenenergiebereich A für amorphes und kristallines Silizium sehr ähnlich.

Die gleichen Überlegungen gelten für kristalline Stoffgemische mit amorphisierten Phasen, soweit die amorphe Phase restlos in eine kristalline Phase überführt werden kann.

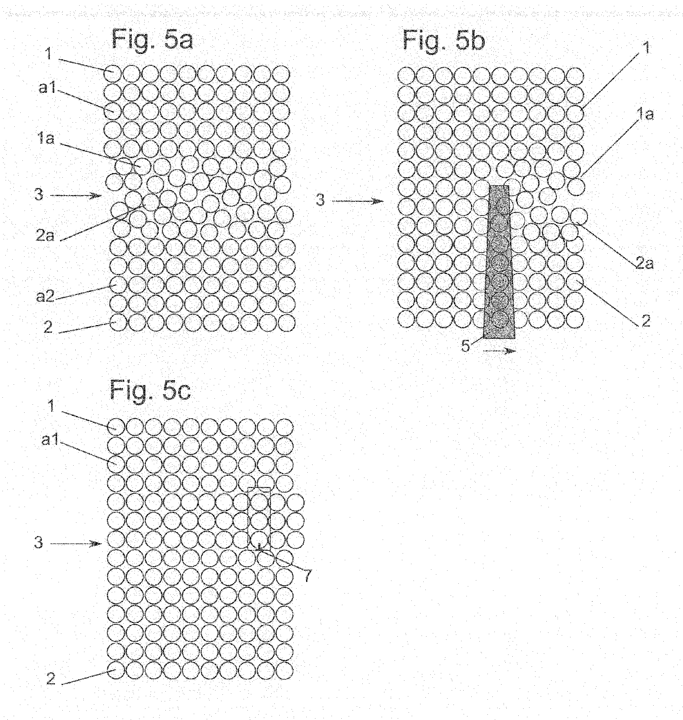

Die Figur 5a zeigt einen vergrößerten, nicht maßstabsgetreuen Substratstapel 3 zweier Substrate 1, 2 mit den entsprechenden amorphen Schichten 1a, 2a. Erkennbar sind die einzelnen Atome a1, a2, aus denen die kristallinen Phasen der Substrate 1, 2 bzw. die amorphen Phasen der amorphen Schichten 1a, 2a aufgebaut sind. Die Atome a1 der kristallinen Phasen der Substrate 1, 2 sind geordnet, die Atome a2 der amorphen Phasen 1a,2a sind ungeordnet.

Die Figur 5b zeigt den vergrößerten, nicht maßstabsgetreuen Substratstapel 3 der Substrate 1, 2 mit den entsprechenden amorphen Schichten 1a, 2a, der mit der Strahlung 5 behandelt wird. Die Strahlung 5 dringt im Wesentlichen ungehindert durch das kristalline Substrat 2, wird dann aber von den amorphen Schichten 1a, 2a absorbiert. Jene Bereiche, die die Strahlung 5 bereits getroffen hat, sind bereits kristallisiert.

Die Figur 5c zeigt den vergrößerten, nicht maßstabsgetreuen Substratstapel 3 zweier beinahe perfekt miteinander verbondeten Substrate 1, 2 ohne entsprechende amorphe Schichten 1a, 2a. Erkennbar ist eine Versetzung 7 am rechten Rand der Figur. Bei der dargestellten Versetzung 7 handelt es sich um eine Stufenversetzung. Sie wurde an Ihrem unteren Ende mit einem, dem Fachmann bekannten, Symbol markiert, sowie zusätzlich strichliert umrandet. Die Stufenversetzung 7 stellt eine zwischen das, ansonsten perfekte, Gitter eingeführte zusätzliche Reihe von Atomen dar. Erkennbar ist die in der Nähe der Versetzung 7 entstehende Verzerrung der Gitteratome. Dem Fachmann auf dem Gebiet sind derartige Defekte bekannt. Es wird explizit erwähnt, dass derartige Defekte bei dem Verfahren entstehen können, aber nicht entstehen müssen.

### Bezugszeichenliste

- 1: Erstes Substrat
- 1a: erste amorphe Schicht eines ersten Substrats
- 1o: Bondoberfläche der ersten Schicht
- 2: Zweites Substrat
- 2a: zweite amorphe Schicht eines zweiten Substrats
- 2o: Bondoberfläche der zweiten Schicht
- 3: Substratstapel
- 4: Strahlungsquelle der Strahlung
- 5: Strahlung
- 6: Drittes Substrat
- 6a: amorphe Schicht des dritten Substrats
- 7: Versetzung
- 8, 9: Absorptionsspektrum
- 10, 11: Brechungsindexgraph
- a1, a2: Atome
- A: Teilchenenergiebereich
- ε: Absorptionsindex
- n: Brechungsindex
- P: Bewegungspfeile

## Patentansprüche

1. Verfahren zum Bonden eines ersten Substrats (1,6) mit einem zweiten Substrat (2), wobei die Substrate (1,2,6) Hybridsubstrate sind und Oberflächen aus einem Dielektrikum, welches elektrisch leitende Bereich umschließt, aufweisen, mit dem folgenden Ablauf:
- Erzeugen einer ersten amorphen Schicht (1a,6a) aus den elektrisch leitenden Oberflächenbereichen auf dem ersten Substrat (1,6) und/oder Erzeugen einer zweiten amorphen Schicht (2a) aus den elektrisch leitenden Oberflächenbereichen auf dem zweiten Substrat (2),
- Verbinden des ersten Substrats (1,6) mit dem zweiten Substrat (2) an der amorphen Schicht (1a,2a,6a) oder an den amorphen Schichten (1a,2a,6a) zur Ausbildung eines Substratstapels (3),
- Bestrahlung der amorphen Schicht (1a,2a,6a) oder der amorphen Schichten (1a,2a,6a) mit einer Strahlung (5) derart, dass die amorphe Schicht (1a,2a,6a) oder die amorphen Schichten (1a,2a,6a) in eine kristalline Schicht oder kristalline Schichten umgewandelt wird/werden.

2. Verfahren nach Anspruch 1, wobei die amorphe(n) Schichten(en) (1a,2a,6a) überwiegend, vorzugsweise vollständig, in eine kristalline Schicht/kristalline Schichten umgewandelt wird/werden.

3. Verfahren nach einem der vorhergehenden Ansprüche, wobei mindestens eines der Substrate (1,2,6) für die Strahlung (5) durchlässig ist, wobei mindestens 50% der Strahlungsenergie der Strahlung (5) durchgelassen wird, bevorzugt mindestens 60%, besonders bevorzugt mindestens 70%, ganz besonders bevorzugt mindestens 80%, weiter bevorzugt mindestens 90%.

4. Verfahren nach einem der vorhergehenden Ansprüche, wobei die amorphe Schicht (1a,2a,6a) die Strahlung (5) zu mehr als 50% der Strahlungsenergie der Strahlung (5) absorbiert, bevorzugt wird mehr als 60% absorbiert, weiter bevorzugt mehr als 70%, besonders bevorzugt mehr als 80%, ganz besonders bevorzugt mehr als 90%.

5. Verfahren nach einem der vorhergehenden Ansprüche, wobei die Strahlung (5) eine Laserstrahlung ist, wobei die Laserstrahlung auf die amorphe(n) Schicht(en) (1a,2a,6a) fokussiert wird.

6. Verfahren nach einem der vorhergehenden Ansprüche, wobei die Strahlung (5) senkrecht auf die amorphe(n) Schicht(en) (1a,2a,6a) auftrifft.

7. Verfahren nach einem der vorhergehenden Ansprüche, wobei die Strahlung (5) durch einen Breitbandstrahler erzeugt wird, der im Energiebereich zwischen 1 eV und 10E8 eV strahlt, vorzugsweise zwischen 1 eV und 10E6 eV, noch bevorzugter zwischen 1 eV und 10E4 eV, am allerbevorzugtesten zwischen 1 eV und 10 eV.

8. Verfahren nach einem der vorhergehenden Ansprüche, wobei die Strahlungsleistung der Strahlung (5) zwischen 0.01 Watt und 10000 Watt liegt, vorzugsweise zwischen 0.1 Watt und 1000 Watt, am allerbevorzugtesten zwischen 1 Watt und 100 Watt.

9. Verfahren nach einem der vorhergehenden Ansprüche, wobei durch die Strahlung (5) in der/den amorphen Schicht(en) (1a,2a,6a) Temperaturen von über 200°C erzeugt werden, bevorzugt über 400°C, besonders bevorzugt über 600°C, noch weiter bevorzugt über 800°C, am bevorzugtesten über 1200°C.

10. Verfahren nach einem der vorhergehenden Ansprüche, wobei die Einstrahlungszeit unter 30 s liegt, bevorzugt unter 15 s, besonders bevorzugt unter 1 s, ganz besonders bevorzugt unter 100 ms.

11. Verfahren nach einem der vorhergehenden Ansprüche, wobei eine Reflexion der Strahlung (5) an Substratflächen und/oder Substratstapelflächen unter 4 % einer Ausgangsintensität einer Strahlungsquelle (4) beträgt, bevorzugt unter 3 %, besonders bevorzugt unter 1%.

12. Verfahren nach einem der vorhergehenden Ansprüche, wobei das erste Substrat (1,6) und/oder das zweite Substrat (2) für die Strahlung (5) zu mindestens 95% einer Ausgangsintensität einer Strahlungsquelle (4) transparent ist, bevorzugt 97% transparent, besonders bevorzugt 99% transparent.

13. Verfahren nach einem der vorhergehenden Ansprüche, wobei vor und/oder während der Bestrahlung eine Heizung mindestens eines der Substrate (1,2,6), bevorzugt beider Substrate (1,2,6), erfolgt, wobei das/die Substrat(e) (1,2,6) über 100°C, bevorzugt über 200°C, besonders bevorzugt über 300°C geheizt werden.

## Claims

1. A method for bonding a first substrate (1, 6) with a second substrate (2), wherein the substrates (1, 2, 6) are hybrid substrates and comprise surfaces made of a dielectric, which encloses an electrically conductive area, with the following sequence:
- Production of a first amorphous layer (1a, 6a) comprising the electrically conductive surface areas on the first substrate (1, 6) and/or production of a second amorphous layer (2a) comprising the electrically conductive surface areas on the second substrate (2),
- bonding of the first substrate (1, 6) with the second substrate (2) to the amorphous layer (1a, 2a, 6a) or to the amorphous layers (1a, 2a, 6a) form a substrate stack (3) ,
- irradiation of the amorphous layer (1a, 2a, 6a) or the amorphous layers (1a, 2a, 6a) with a radiation (5), in such a way that the amorphous layer (1a, 2a, 6a) or the amorphous layers (1a, 2a, 6a) is/are converted into a crystalline layer or crystalline layers.

2. The method according to claim 1, wherein the amorphous layer(s) (1a, 2a, 6a) is/are predominantly, preferably completely, converted into a crystalline layer/crystalline layers.

3. The method according to any one of the preceding claims, wherein at least one of the substrates (1, 2, 6) is transparent for the radiation (5), wherein at least 50% of the radiant energy of the radiation (5) is passed through, preferably at least 60%, particularly preferably at least 70%, very particularly preferably at least 80%, more preferably at least 90%.

4. The method according to any one of the preceding claims, wherein the amorphous layer (1a, 2a, 6a) and the radiation (5) absorbs up to more than 50% of the radiant energy of the radiation (5), preferably more than 60% is absorbed, more preferably more than 70%, particularly preferably more than 80%, very particularly preferably more than 90%.

5. The method according to any one of the preceding claims, wherein the radiation (5) is laser radiation, wherein the laser radiation is focused on the amorphous layer(s) (1a, 2a, 6a) .

6. The method according to any one of the preceding claims, wherein the radiation strikes the amorphous layer(s) (1a, 2a, 6a) at right angles.

7. The method according to any one of the preceding claims, wherein the radiation (5) is produced by a broadband emitter, which radiates in the energy range between 1 eV and 10 E8 eV, preferably between 1 eV and 10 E6 eV, still more preferably between 1 eV and 10 E4 eV, most preferably between 1 eV and 10 eV.

8. The method according to any one of the preceding claims, wherein the radiant power of the radiation (5) lies between 0.01 Watt and 10,000 Watt, preferably between 0.1 Watt and 1000 Watt, with utmost preference between 1 Watt and 100 Watt.

9. The method according to any one of the preceding claims, wherein temperatures of over 200°C are produced by the radiation (5) in the amorphous layer(s) (1a, 2a, 6a), preferably over 400°C, particularly preferably over 600°C, still more preferably over 800° C, most preferably over 1200°C.

10. The method according to any one of the preceding claims, wherein the irradiation time lies below 30 s, preferably below 15 s, particularly preferably below 1 s, very particularly preferably below 100 ms.

11. The method according to any one of the preceding claims, wherein a reflection of the radiation (5) at substrate surfaces and/or substrate stack surfaces amounts to less than 4% of an initial intensity of a radiation source (4), preferably less than 3%, particularly preferably less than 1%.

12. The method according to any one of the preceding claims, wherein the first substrate (1, 6) and/or the second substrate (2) is transparent for the radiation (5) up to at least 95% of an initial intensity of a radiation source (4), preferably 97% transparent, particularly preferably 99% transparent.

13. The method according to any one of the preceding claims, wherein heating of at least one of the substrates (1, 2, 6), preferably both substrates (1, 2, 6), takes place before and/or during the irradiation, wherein the substrate(s) (1, 2, 6) are heated above 100°C, preferably above 200°C, particularly preferably above 300°C

## Revendications

1. Procédé, destiné à lier un premier substrat (1, 6) avec un deuxième substrat (2), les substrats (1, 2, 6) étant des substrats hybrides et comportant des surfaces en un diélectrique, lequel entoure des zones conductrices d'électricité, présentant le déroulement suivant, consistant à :
- créer une première couche (1a, 6a) amorphe à partir des zones de surface conductrices d'électricité sur le premier substrat (1, 6) et / ou créer une deuxième couche (2a) amorphe à partir de zones de surface conductrices d'électricité sur le deuxième substrat (2),
- assembler le premier substrat (1, 6) avec le deuxième substrat (2) sur la couche (1a, 2a, 6a) amorphe ou sur les couches (la ,2a, 6a) amorphes, pour constituer une pile de substrats (3),
- irradier la couche (la, 2a, 6a) amorphe ou les couches (la, 2a, 6a) amorphes avec un rayonnement (5), de telle sorte que la couche (1a, 2a, 6a) amorphe ou les couches (la, 2a, 6a) amorphes soi(en)t transformée(s) en une couche cristalline ou en des couches cristallines.

2. Procédé selon la revendication 1, la / les couche(s) (1a, 2a, 6a) amorphes étant transformée(s) majoritairement, de préférence totalement en une couche cristalline/en des couches cristallines.

3. Procédé selon l'une quelconque des revendications précédentes, au moins l'un des substrats (1, 2, 6) étant perméable au rayonnement (5), au moins 50 %, de préférence au moins 60 %, de manière particulièrement préférentielle, au moins 70 %, de manière tout particulièrement préférentielle, au moins 80 %, de manière encore plus préférentielle, au moins 90 % de l'énergie rayonnante du rayonnement (5) étant transmis,

4. Procédé selon l'une quelconque des revendications précédentes, la couche (la, 2a, 6a) amorphe absorbant le rayonnement (5) à raison de plus de 50 % de l'énergie rayonnante du rayonnement (5), de préférence, plus de 60 % sont absorbés, de manière plus préférentielle, plus de 70 %, de manière particulièrement préférentielle, plus de 80%, de manière tout particulièrement préférentielle, plus de 90 %.

5. Procédé selon l'une quelconque des revendications précédentes, le rayonnement (5) étant un rayonnement laser, le rayonnement laser étant focalisé sur la / les couche(s) (la, 2a, 6a) amorphes.

6. Procédé selon l'une quelconque des revendications précédentes, le rayonnement (5) étant incident à la perpendiculaires sur la / les couche(s) (la, 2a, 6a) amorphe(s).

7. Procédé selon l'une quelconque des revendications précédentes, le rayonnement (5) étant créé par un émetteur à large bande, qui émet dans la plage énergétique comprise entre 1 eV et 10E8 eV, de préférence entre 1 eV et 10E6 eV, de manière encore plus préférentielle, entre 1 eV et 10E4 eV, de la manière la plus préférentielle, entre 1 eV et 10 eV.

8. Procédé selon l'une quelconque des revendications précédentes, la puissance rayonnée du rayonnement (5) se situant entre 0.01 watt et 10000 watts, de préférence entre 0.1 watt et 1000 watts, de la manière la plus préférentielle, entre 1 watt et 100 watts.

9. Procédé selon l'une quelconque des revendications précédentes, par le rayonnement (5) dans la / les couche(s) (la, 2a, 6a) amorphes étant créées des températures supérieures à 200 °C, de préférence supérieures à 400 °C, de manière particulièrement préférentielle, supérieures à 600 °C, de manière encore plus préférentielle, supérieures à 800°C, de la manière la plus préférentielle, supérieures à 1200°C.

10. Procédé selon l'une quelconque des revendications précédentes, la durée d'irradiation étant inférieure à 30 secondes, de préférence inférieure à 15 secondes, de manière particulièrement préférentielle, inférieure à 1 seconde, de manière tout particulièrement préférentielle, inférieure à 100 m/secondes.

11. Procédé selon l'une quelconque des revendications précédentes, une réflexion du rayonnement (5) sur des surfaces de substrat et / ou sur des surface de piles de substrats étant inférieure à 4 %, de préférence inférieure à 3 %, de manière particulièrement préférentielle, inférieure à 1 % d'une intensité initiale d'une source de rayonnement (4).

12. Procédé selon l'une quelconque des revendications précédentes, le premier substrat (1, 6) et / ou le deuxième substrat (2) étant transparent(s) au rayonnement (5) à raison d'au moins 95 %, de préférence transparent(s) à raison de 97 % , de manière particulièrement préférentielle, transparent(s) à raison de 99 % d'une intensité initiale d'une source de rayonnement (4),

13. Procédé selon l'une quelconque des revendications précédentes, avant et / ou pendant l'irradiation ayant lieu un chauffage d'au moins l'un des substrats (1, 2, 6), de préférence, des deux substrats (1, 2, 6), le / les substrat(s) (1, 2, 6) étant chauffés à plus de 100 °C, de préférence à plus de 200 °C, de manière particulièrement préférentielle, à plus de 300 °C.
